Europäisches Patentamt

European Patent Office

Office européen des brevets

(11) Numéro de publication: **0 210 932 B1**

# FASCICULE DE BREVET EUROPEEN

(45) Date de publication de fascicule du brevet:
24.07.91

(51) Int. Cl.5: **H03M 13/12**, //G06F11/10

(21) Numéro de dépôt: 86401719.9

(22) Date de dépôt: 31.07.86

(54) **Procédé de décodage d'un code convolutif et décodeur correspondant.**

(30) Priorité: 02.08.85 FR 8511863

(43) Date de publication de la demande:
04.02.87 Bulletin 87/06

(45) Mention de la délivrance du brevet:
24.07.91 Bulletin 91/30

(84) Etats contractants désignés:
DE GB NL

(56) Documents cités:
US-A- 3 457 562
US-A- 4 087 787
US-A- 4 322 848

IEEE TRANSACTIONS ON COMMUNICA-
TIONS, vol. COM-31, no. 2, février 1983, pages 165-171, IEEE, New York, US; J. CONAN:
"An F8 microprocessor-based breadboard
for the simulation of communication links
using rate 1/2 convolutional codes and Viterbi decoding"

IEEE TRANSACTIONS ON INFORMATION
THEORY, vol. IT-21, no. 6, novembre 1975,
pages 638-651, IEEE, New York, US; D. HAC-
COUN et al.: "Generalized stack algorithms

for decoding convolutional codes"

IEEE TRANSACTIONS ON COMMUNICATIONS
TECHNOLOGY, vol. COM-19, no. 5, octobre
1971, pages 751-772, IEEE, New York, US; A.J.
VITERBI: "Convolutional codes and their performance in communication systems"

IBM TECHNICAL DISCLOSURE BULLETIN, vol.
13, no. 7, decembre 1970, pages 1775-1780,
New York, US; F. JELINEK: "Fast sequential
decoding algorithm"

(73) Titulaire: Battail, Gérard
9, Place de Rungis
F-75013 Paris(FR)

(72) Inventeur: Battail, Gérard
9, Place de Rungis
F-75013 Paris(FR)

(74) Mandataire: Mongrédien, André et al
c/o BREVATOME 25, rue de Ponthieu
F-75008 Paris(FR)

## Description

La présente invention a pour objet un procédé de décodage d'une suite de symboles reçus d'un canal perturbé, résultant du codage convolutif d'une suite de symboles d'information à transmettre.

Les codes convolutifs, qui sont aussi appelés récurrents, séquentiels, convolutionnels ou en arbre sont utilisés notamment sur les liaisons spatiales. Ces liaisons, fortement perturbées par le bruit thermique, sont protégées efficacement en utilisant un code convolutif intérieur concaténé avec un code extérieur, généralement du type Reed-Solomon.

Les symboles à transmettre et les symboles du code convolutif sont pris dans un alphabet q-aire qui, dans la plupart des applications, est l'alphabet binaire (q = 2) car, pour des alphabets de plus grande taille (q > 2), le codeur et surtout le décodeur deviennent rapidement très complexes. Pour ces raisons, on se référera presque exclusivement au cas où q = 2 dans la suite de la description. Nous n'évoquerons le cas général (q ≠ 2) que lorsque la transposition du cas q = 2 au cas q ≠ 2 n'est pas immédiate pour l'homme de l'art.

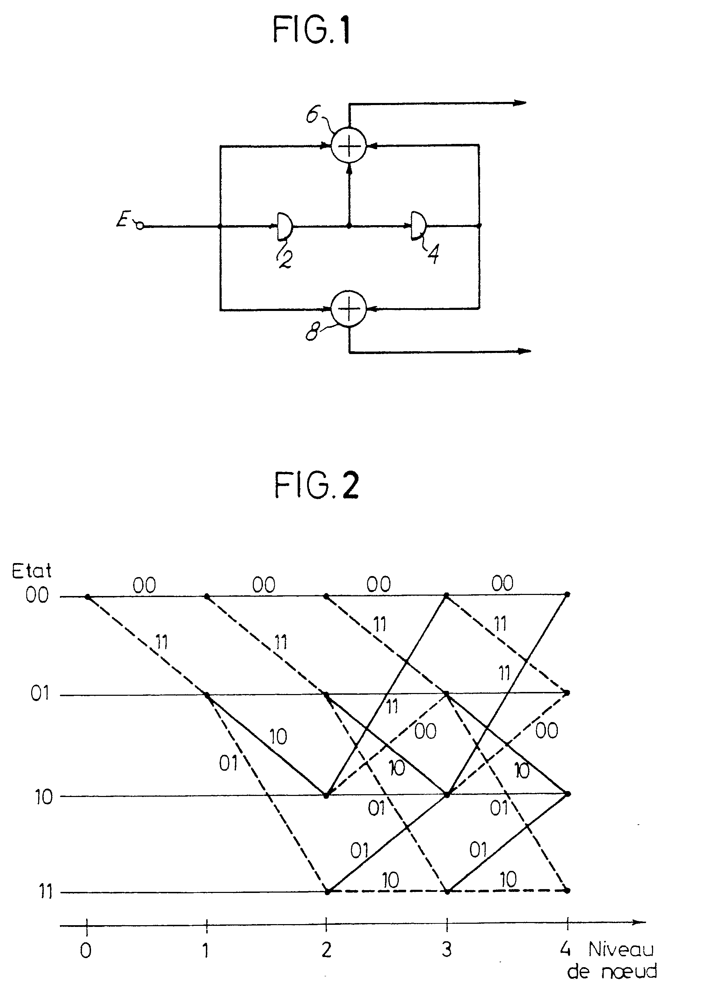

On rappelle qu'un code convolutif est engendré par combinaison linéaire des symboles mémorisés dans un registre alimenté et décalé par les symboles à transmettre. L'exemple classique d'un codeur convolutif est représenté sur la figure 1.

Ce codeur comprend deux éléments à retard 2, 4 en série qui constituent un registre à décalage, un premier additionneur 6 pour faire la somme modulo 2 du symbole d'information appliqué sur l'entrée E du codeur et des deux symboles retardés et un second additionneur pour faire la somme modulo 2 du symbole d'information appliqué sur l'entrée E du codeur et du symbole retardé délivré par l'élément à retard 4. L'entrée E du codeur correspond à l'entrée de l'élément à retard 2 ; les sorties du codeur sont constituées par les sorties des additionneurs 6, 8.

Les symboles d'information entrent un par un dans le codeur de la figure 1. L'introduction de chaque symbole d'information entraîne l'émission de deux symboles codés, obtenus par combinaison linéaire du symbole qui vient d'être introduit et des deux (m dans le cas général, où m ≠ 0) symboles précédents retardés. L'état du codeur est défini par le vecteur ayant pour composantes les symboles retardés.

De manière générale, les symboles entrent k par k dans le codeur, chacun d'eux étant appliqué sur l'entrée d'un registre à décalage. L'introduction de chaque ensemble de k symboles d'information entraîne l'émission de n symboles codés (n > k), obtenus par combinaison linéaire des k symboles qui viennent d'être introduits et de mk (m ≠ 0) symboles précédents retardés.

De manière classique, le décodage d'un code convolutif est réalisé au moyen de l'algorithme de Viterbi. Cet algorithme, décrit notamment dans l'article "Error bounds for convolutional codes and an asymptically optimum decoding algorithm", IEEE Trans. on Inf. Theory, IT-13, 1967, pp. 260-269 de A. J. VITERBI, est un moyen de décodage optimal au sens de la vraisemblance maximale. Il peut être interprété comme un moyen d'estimation de la suite des états du codeur, donc de la suite des symboles d'information, à partir de la suite des symboles codés, reçue à travers un canal perturbé.

Il n'est pas inutile de rappeler le principe de l'algorithme de Viterbi. On remarque d'abord que les symboles d'information étant discrets, le nombre des états est fini ; ce nombre est égal à 4 dans le cas de la figure 1, et à $q^{km}$ en général. Un même état peut donc être atteint à partir de deux états qui ne diffèrent que par le symbole le plus ancien présent dans la mémoire du codeur, puisque ce symbole en disparaît dès le décalage consécutif à l'introduction d'un nouveau symbole d'information. Ce symbole est appelé "symbole sortant" et les deux états ($q^k$ états en général) menant directement à l'état considéré sont appelés ses antécédents.

Si l'on suppose un état quelconque effectivement atteint, une décision peut être prise quant au symbole sortant, car les symboles codés reçus ultérieurement cessent définitivement d'en dépendre, donc de renseigner sur lui. L'algorithme de Viterbi consiste à prendre une décision définitive quant au symbole sortant pour chacun des états possibles. Le choix d'un seul état à chaque instant n'est déterminé que plus tard, après un nombre aléatoire de décisions ultérieures, car la progression de l'algorithme tend à éliminer toute succession d'états incompatible avec la structure de registre du codeur.

Le fonctionnement de l'algorithme est illustré traditionellement par le diagramme du treillis qui a été proposé par G.D. FORNEY Jr dans l'article "The Viterbi Algorithm", Proc. IEEE, 61, n° 3, mars 1973, pp 268-278.

On a représenté sur la figure 2 le diagramme du treillis correspondant au codeur de la figure 1. L'abscisse, entière, représente le temps ; l'ordonnée, également entière, chacun des états. Les points discrets ainsi déterminés sont dits noeuds et leur abscisse est désignée par niveau de noeud. Les transitions possibles entre les noeuds sont représentées par des branches orientées de gauche à droite (sens des niveaux de noeud croissants). Toute suite connectée de branches, à laquelle correspond une suite possible de symboles d'information et la suite correspondante de symboles codés, est appelée chemin. Dans le diagramme, les branches en trait plein et en trait tireté représentent respectivement les symboles d'information "0" et "1" ; les couples de chiffres binaires associés à chaque branche sont les symboles codés correspondants.

Le décodage d'une suite de symboles codés reçus se traduit dans cette représentation de l'algorithme par la détermination du meilleur chemin pour le critère de vraisemblance. Pour chaque noeud, on détermine le chemin de plus grande vraisemblance y convergeant, et seul finit par subsister le chemin de vraisemblance maximale.

L'algorithme connu qui vient d'être décrit permet d'obtenir la meilleure estimation de la suite des états et donc de la suite des symboles d'information. Cependant, ce procédé ne donne aucune information sur la fiabilité des symboles d'information déterminés. Or, cette information permet d'améliorer le décodage dans certains cas particuliers intéressant notamment les liaisons spatiales.

On a déjà indiqué qu'on utilise dans ce cas un code convolutif intérieur concaténé avec un code extérieur de type Reed-Solomon. Après le décodage du code convolutif, les erreurs résiduelles sont en général groupées en courts paquets que le code de Reed-Solomon corrige avec une particulière efficacité. Or, le décodage du code extérieur peut être grandement amélioré si ces paquets d'erreurs sont localisés et, plus encore, si les symboles à décoder sont pondérés en fonction de leur fiabilité.

Cette information de fiabilité est disponible en principe, car toute décision de démodulation ou de décodage peut être interprétée comme déduite d'une comparaison des probabilités des diverses hypothèses possibles a priori. Le seul problème est donc de rendre cette information explicite. Par ailleurs, une estimation globale de la fiabilité de la décision concernant une longue suite de symboles d'information n'aurait guère d'utilité, car dans le cas du décodage concaténé, on souhaite au moins localiser les paquets d'erreurs résiduelles.

La pondération des symboles décodés est déjà connue en soi dans le cas des codes linéaires, qui incluent les codes convolutifs. Pour une description complète, on pourra se reporter par exemple à l'article "Décodage par répliques" paru dans Annales des Télécommunications, tome 31, n° 11-12, nov-déc 1976, pp 387-404 de G. BATTAIL et M. DECOUVELAERE.

La mise en oeuvre habituelle de l'algorithme de Viterbi consiste à associer deux mémoires à chacun des états possibles. L'une d'elles contient la meilleure suite de symboles d'information qui mène à cet état et que l'on appelle la survivante ; l'autre contient une mesure de la vraisemblance cumulée de cette suite. Le contenu de l'une et l'autre de ces mémoires est déduit de celui des mémoires associées au noeud antécédent situé sur le meilleur chemin. La vraisemblance cumulée est modifiée par addition de celle de la branche qui mène au noeud considéré. Quant à la suite des symboles, elle est recopiée et augmentée du dernier symbole déterminé. Pour éviter de devoir garder en mémoire une suite de symboles dont la longueur croît indéfiniment avec le temps, on se contente d'un registre de longueur L suffisante où le contenu du registre précédent est transféré et décalé par introduction du dernier symbole déterminé (nous utiliserons dans la suite le terme "transfert décalé" pour désigner cette opération). Alors, les symboles sortant des registres associés aux différents états sont presque toujours identiques (si le registre est assez long) et leur suite constitue le résultat définitif du décodage.

On va maintenant indiquer comment est obtenue une pondération symbole par symbole. Cette pondération connue va être décrite dans le cas particulier où les symboles sont binaires. Ces symboles sont notés "0" et "1". La sortie du décodeur peut donc être simplement connectée à celle de l'un des registres associés aux états, choisi arbitrairement. Il est cependant préférable de prendre pour symbole d'information décodé le résultat d'une décision majoritaire sur la totalité des symboles qui sortent simultanément des registres associés aux états (on pourra se reporter sur ce point au livre de A.J. VITERBI et J.K. OMURA, "Principles of Digital Communication and Coding", Mc Graw-Hill, 1979).

Pour un noeud donné, la différence entre les vraisemblances cumulées des deux chemins qui y aboutissent est égale à la valeur relative du symbole sortant, par définition même de cette grandeur, c'est-à-dire le logarithme du rapport des probabilités de réalisation des deux hypothèses "0 émis" et "1 émis". Son signe indique donc quel est le symbole déterminé (" + " correspond à "0" et "-" à "1") tandis que sa valeur absolue mesure la fiabilité de la décision prise ; en particulier, elle est nulle dans le cas d'indétermination où ces deux probabilités sont égales. On obtient une pondération de la forme souhaitée en mettant en mémoire, pour chaque état, la suite des valeurs relatives ainsi calculées au lieu de la suite des seuls symboles.

On obtient ainsi autant de suites de valeurs relatives qu'il y a d'états possibles. On peut dès lors, comme dans l'algorithme sous sa forme habituelle, ne conserver que la suite de valeurs relatives associée à chaque survivant. Ce faisant, on ne change rien au transfert décalé, sinon que l'on remplace les symboles par des nombres réels. Cette solution simple n'est pas pleinement satisfaisante. En effet, le choix du symbole sortant en un noeud peut être fait avec une faible marge alors que les suites de valeurs relatives associées à chacun des chemins qui y convergent peuvent être très différentes.

L'invention consiste à améliorer la suite des valeurs relatives survivantes en un noeud en tenant compte des deux chemins qui ont servi à la déterminer, c'est-à-dire en tenant compte des deux suites de valeurs relatives associées à chacun des antécédents du noeud considéré.

Plus précisément, si x' et x" sont deux valeurs relatives, correspondant à un même niveau de noeud, appartenant respectivement aux suites survivantes en les antécédents du noeud considéré et si z est la différence des vraisemblances des deux chemins aboutissant au noeud considéré, c'est-à-dire la dernière valeur relative déterminée, le procédé de l'invention consiste à pondérer la probabilité des symboles d'information correspondant à x' et x", de chacun des deux chemins, par la probabilité de ce chemin conditionnellement au fait qu'il mène au noeud considéré. Cette pondération est effectuée pour chaque couple de valeurs relatives correspondant à un même niveau de noeud des chemins des antécédents du noeud considéré.

L'invention s'applique également au cas non binaire ($q \neq 2$). Le nombre réel signé qui constitue la valeur relative est alors remplacé par un vecteur de q-1 nombres réels dont la composante i ($1 \leq i \leq q-1$) est définie comme le logarithme du rapport des probabilités des deux hypothèses "O émis" et "i émis" (les symboles de l'alphabet q-aire étant notés 0, 1, 2,..., i,..., q-1).

L'invention a également pour objet un décodeur pour la mise en oeuvre du procédé.

Les caractéristiques et avantages de l'invention ressortiront mieux de la description qui va suivre, donnée à titre illustratif mais non limitatif, en référence aux dessins annexés, sur lesquels :

- la figure 1, déjà décrite, est un exemple d'un codeur convolutif classique,
- la figure 2, déjà décrite, illustre le diagramme du treillis associé au codeur de la figure 1, utilisé classiquement pour le décodage,
- la figure 3 est un élément de treillis montrant la pondération conformément à l'invention,
- la figure 4 est un graphe représentant la valeur relative révisée conformément à l'invention en fonction des valeurs relatives x' et x" et de la valeur relative z, et
- la figure 5 est un mode de réalisation d'un module du décodeur de l'invention, le décodeur complet étant constitué d'un ensemble de modules identiques, chaque module étant associé à un état et les différents modules étant reliés entre eux suivant les relations d'antécédence dans le treillis associé au codeur.

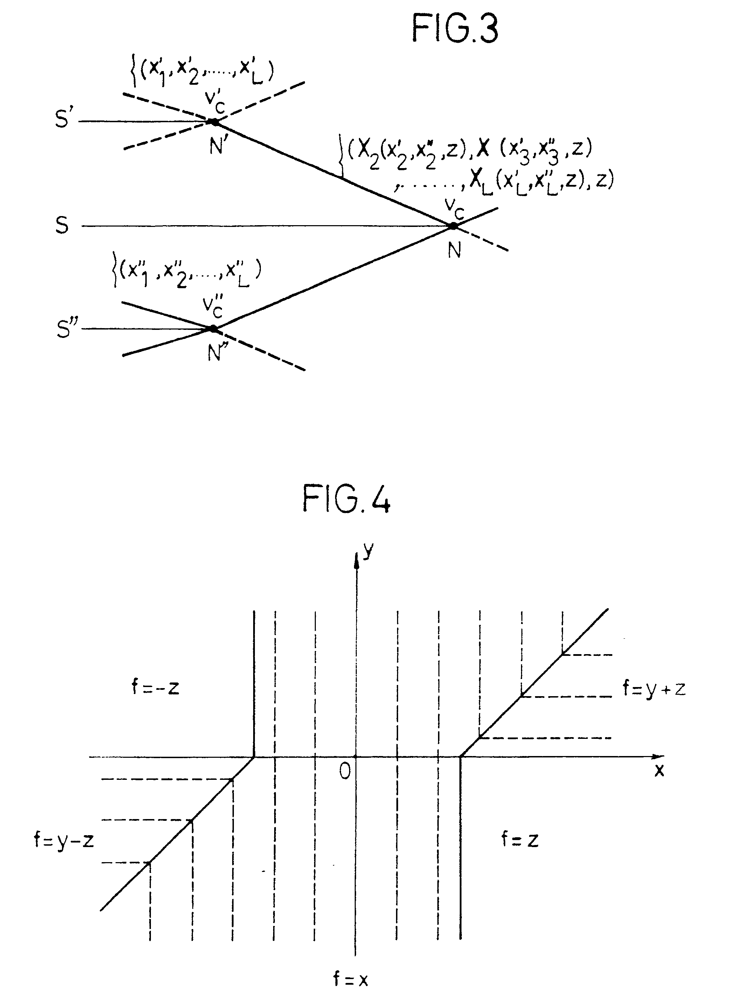

On a représenté sur la figure 3 un élément de treillis comprenant un noeud N d'ordonnée (i.e. d'état) S et ses deux antécédents N' et N" d'états S' et S". Le chemin le plus vraisemblable, ou survivant, au niveau du noeud N' est défini par la suite de valeurs relatives $x'_1$, $x'_2$,...$x'_L$. La fiabilité attachée à cette suite, appelée aussi vraisemblance cumulée, est notée $v'_c$. De même, pour le noeud N", situé au même niveau que le noeud N', le chemin le plus vraisemblable est défini par la suite de valeurs relatives $x"_1$, $x"_2$,...$x"_L$. La vraisemblance cumulée de ce chemin est notée $v"_c$.

Dans le procédé de décodage selon l'art antérieur, le choix du dernier symbole déterminé, correspondant à la transition entre le niveau des noeuds N', N", et le noeud N, fixe directement la suite des valeurs relatives associée au noeud N : si la valeur relative z correspondant au dernier symbole déterminé est positive, le chemin le plus vraisemblable est celui provenant du noeud N' ; la suite de valeurs relatives associée au noeud N est alors $x'_2$, $x'_3$,...,$x'_L$, z. Elle est obtenue par simple transfert décalé de la suite de valeurs relatives associées au noeud N'. De même, si la valeur relative z est négative, la suite de valeurs relatives associée au noeud N est $x"_2$, $x"_3$,...,$x"_L$, z. Elle est également obtenue par simple transfert décalé de la suite de valeurs relatives associée au noeud N".

La valeur relative z détermine donc des choix tranchés entre les valeurs relatives $x'_2$ et $x"_2$, $x'_3$ et $x"_3$,..., $x'_L$ et $x"_L$. Or, les deux valeurs relatives associées à un même niveau de noeud $x'_i$ et $x"_i$ (où $2 \leq i \leq L$) peuvent correspondre à des valeurs binaires estimées l'une et l'autre très fiables (modules importants), mais pourtant contradictoires (signes opposés).

Dans le procédé de l'invention, au contraire, le choix tranché d'une suite de valeurs relatives de préférence à l'autre est remplacé par une décision pondérée en fonction de la vraisemblance des deux chemins comparés. Toutes les valeurs relatives, sauf la dernière, de la suite des valeurs relatives $X_2$, $X_3$,... $X_L$, z associée au chemin survivant au niveau du noeud N sont ainsi fonction des valeurs relatives de même niveau de noeud des deux chemins comparés, et de la valeur relative z. La décision pondérée que représentent les valeurs relatives $X_2$,..., $X_L$ est elle-même révisée lors de la détermination des survivants correspondant aux noeuds des niveaux suivants.

L'expression d'une valeur relative révisée X en fonction des valeurs relatives x', x" et z s'obtient de la manière suivante. Si l'on note b le symbole sortant correspondant au niveau de noeud commun à x' et x", et d le dernier symbole sortant déterminé, correspondant à z, on a, par définition des valeurs relatives :

Pr (b = 0 | d = 0) = 1/(1 + e$^{-x'}$)
Pr (b = 0 | d = 1) = 1/(1 + e$^{-x''}$)
Pr (d = 0) = 1/(1 + e$^{-z}$), et
Pr (d = 1) = 1/(1 + e$^{z}$),

où Pr(A|B) est la probabilité de l'événement A conditionnellement à l'événement B, Pr(A) est la probabilité de l'événement A.

La probabilité d'avoir b = 0 compte tenu de x', x" et z (exclusivement) est donc :

$$1/(1 + e^{-X}) = Pr(b = 0|d = 0).Pr(d = 0) + Pr(b = 0|d = 1).Pr(d = 1),$$

ce qui donne, après transformation :

$$X = \log_e(e^{x''} + e^{x' + x''} + e^{x'' + z} + e^{x' + x'' + z}) - \log_e(1 + e^{x'} + e^{x''} + e^{x'' + z})$$

On voit aisément qu'il s'agit d'une fonction monotone de z pour x' et x" donnés, variant de x" (pour z = -∞) à x' (pour z = +∞). Le remplacement de z par -z et l'échange de x' et x" laissent cette expression invariante.

La complication de cette expression exacte rend son emploi difficile. La forte variation de la fonction exponentielle suggère de la remplacer par l'expression qui s'en déduit en ne conservant dans chaque parenthèse que la plus grande des exponentielles. Alors, la valeur relative révisée devient approximativement :

$$X = \max(x'', x' + x'', x' + z, x' + x'' + z) - \max(0, x', z, x'' + z) = f(x', x'', z),$$

où max est la fonction "maximum". Cette approximation est parfois grossière, mais paraît suffisante dans la plupart des cas.

La fonction f(x', x", z) est représentée sur la figure 4 pour z > 0. La forme obtenue pour z négatif s'en déduit par symétrie puisque f(x', x", z) = f(x", x', -z). Les lignes en pointillé sont des lignes de niveau f = constante.

L'examen de cette figure montre que la révision des valeurs relatives utilisant la formule simplifiée ne change rien dans la zone centrale où f(x', x", z) = x'. L'existence des "plateaux" aux cotes z et -z montre en revanche que cette révision a pour effet de limiter le module de la valeur relative à celui de z lorsque x' et x" sont de grand module et de signes contraires, c'est-à-dire correspondent à des décisions binaires estimées l'une et l'autre très fiables, mais pourtant contradictoires. La discussion de la formule exacte de la valeur révisée, un peu plus compliquée, aboutit à des conclusions analogues.

On va maintenant décrire un décodeur pour la mise en oeuvre du procédé de l'invention. De manière classique, un décodeur peut être constitué d'un ensemble de modules identiques, un module étant associé à chaque état du treillis et les différents modules étant reliés entre eux selon les relations d'antécédence.

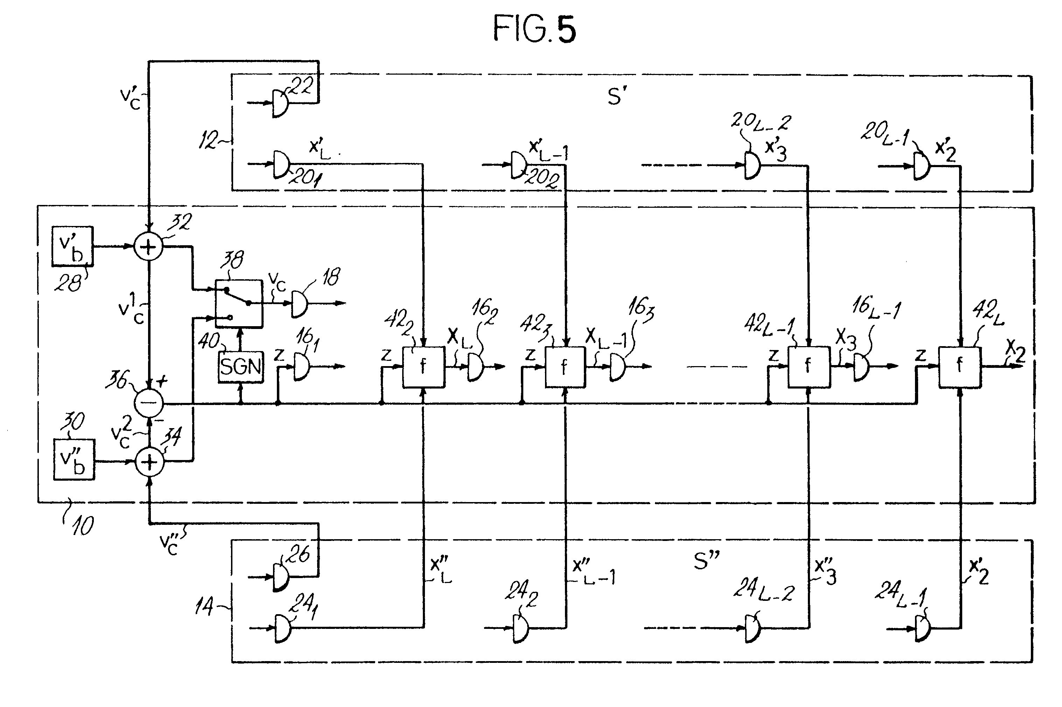

Sur la figure 5, on a représenté le module 10 d'un état S, qui est l'ordonnée d'un noeud N à un instant donné, et les principaux éléments des modules 12 et 14 associés aux états S' et S" correspondant aux antécédents N' et N" du noeud N. Le module 10 comprend un ensemble de mémoires analogiques $16_1$, $16_2$,..., $16_{L-1}$, qui peuvent être des éléments à retard, pour mémoriser la suite des valeurs relatives associée à l'état S, à l'exception de la valeur relative la plus ancienne puisque celle-ci disparaît au cours du transfert décalé. Il comprend également une mémoire analogique 18 pour mémoriser la vraisemblance cumulée $v_c$ du chemin le plus vraisemblable aboutissant à l'état S. Les modules 12 et 14 comprennent de manière similaire des mémoires analogiques $20_1$, $20_2$,..., $20_{L-1}$ et 22 pour l'état S' et des mémoires analogiques $24_1$, $24_2$,..., $24_{L-1}$ et 26 pour l'état S".

De manière classique, le module 10 comprend également des moyens pour calculer la valeur relative correspondant à la transition entre les états S' et S" d'une part, et l'état S d'autre part. Ces moyens sont constitués d'un moyen de calcul 28 de la vraisemblance $v'_b$ du symbole associé à la branche entre les noeuds N' et N d'états respectifs S' et S, d'un moyen de calcul 30 de la vraisemblance $v''_b$ du symbole associé à la branche entre les noeuds N" et N d'états respectifs S" et S, d'un additionneur 32 pour produire la vraisemblance cumulée $v_c^1$ égale à $v'_c + v'_b$, d'un additionneur 34 pour produire la vraisemblance cumulée $v_c^2$ égale à $v''_c + v''_b$, d'un soustracteur 36 pour produire la valeur relative z égale à $v_c^1 - v_c^2$, et d'un commutateur 38, commandé par un moyen 40 recevant en entrée la valeur relative z, et qui délivre la vraisemblance cumulée $v_c$ associée au chemin survivant du noeud N d'état S. Cette vraisemblance cumulée

$v_c$ est la plus grande des deux vraisemblances cumulées $v_c^1$ et $v_c^2$.

Chaque module du décodeur de l'invention comprend en outre, de manière caractéristique, des moyens de traitement $42_2$, $42_3$,..., $42_{L-1}$ disposés en amont des mémoires analogiques $16_2$, $16_3$,..., $16_{L-1}$ et un dernier moyen de traitement $42_L$. Chaque moyen de traitement comporte trois entrées qui reçoivent respectivement une valeur relative $x_i'$, $2 \leq i \leq L$, du module 12 de l'antécédent S' ; une valeur relative $x_i''$, $2 \leq i \leq L$, du module 14 de l'antécédent S" ; et la valeur relative z produite par le soustracteur 36.

Les connexions entre les mémoires analogiques des modules 12, 14 des états S', S" avec les moyens de traitement du module 10 de l'état S, et les connexions entre ces moyens de traitement et les mémoires analogiques du module 10 permettent de réaliser un transfert décalé pondéré des suites de valeurs relatives des modules 12, 14 dans le module 10.

Les moyens de traitement produisent les valeurs relatives révisées $X_2$, $X_3$,..., $X_n$ selon les équations données plus haut. La sortie du décodeur, comme dans le cas de décisions binaires non pondérées, peut être simplement connectée à celle de l'un quelconque des registres des valeurs relatives associés aux états. Il est toutefois préférable de prendre pour résultat définitif du décodage la moyenne arithmétique des valeurs relatives sortant simultanément de la totalité des registres associés aux états.

Dans les décodeurs selon l'art antérieur, ces moyens de traitement se réduisent à des commutateurs commandés simultanément pour réaliser un transfert décalé non pondéré soit de la suite des valeurs relatives correspondant à l'état S', soit de la suite des valeurs relatives correspondant à l'état S".

Dans la description qui précède, l'invention a été présentée dans le cas particulier où les symboles sont pris dans un alphabet binaire et sont présentés un à un dans un codeur, ceci pour ne pas alourdir inutilement la description. Il apparaît à l'évidence à l'homme de l'art que le procédé et le décodeur décrits peuvent être transposés aisément pour être adaptés au cas général où $q \neq 2$. La seule différence notable entre le cas particulier $q = 2$ et le cas général réside dans la transposition de la notion de valeur relative. Nous allons donc préciser ce point.

Dans un alphabet de taille q, on définit la valeur relative vectorielle comme un vecteur $\underline{a}$ de dimension q-1 ayant pour $i^{ème}$ composante :

$$a_i = \log_e(Pr(s = 0)) - \log_e(Pr(s = i)), \; i = 1, 2,..., q-1$$

complété si besoin est par une composante d'indice 0 systématiquement prise égale à 0.

Cette définition est en partie arbitraire puisqu'elle fait jouer au symbole "O" un rôle particulier. Elle présente cependant l'avantage que le vecteur $\underline{a}$ se réduit à un scalaire égale à la valeur relative, telle que définie au cours de la description, dans le cas où $q = 2$.

Avec cette définition, le calcul de la valeur relative vectorielle révisée se transpose immédiatement du cas $q = 2$. Si s est le symbole sortant correspondant à un certain niveau de noeud plus petit que le niveau atteint et d le dernier symbole sortant déterminé, pour un état donné, et si $\underline{a}^j$ est le vecteur des valeurs relatives qui lui est associé dans l'hypothèse où la dernière décision est en faveur de j et z celui qui est associé à la dernière décision (donc déterminé à partir des différences des vraisemblances associées aux divers chemins convergeant au noeud considéré), on a :

$$Pr(s = i \mid d = j) = \exp(-a_i^j) . Pr(s = 0 \mid d = j) \text{ et}$$
$$Pr(d = j) = \exp(-z_j) . Pr(d = 0).$$

Par ailleurs, l'égalité à 1 de la somme des probabilités $Pr(s = i \mid d = j)$ pour i de 0 à q-1 entraîne :

$$Pr(s=0 \mid d=j) + Pr(s=0 \mid d=j) . \sum_{k=1}^{q-1} \exp(-a_k^j) = 1, \text{ d'où}$$

$$Pr(s=0 \mid d=j) = 1 / \left(1 + \sum_{k=1}^{q-1} \exp(-a_k^j)\right).$$

Si R est le symbole révisé en fonction de la nouvelle décision d et $\underline{A}$ le vecteur des valeurs relatives qui lui est associé, on a :

$$Pr(R=i) = Pr(d=0) \cdot \sum_{j=0}^{q-1} exp(-a_i^j - z_j)/(1 + \sum_{k=1}^{q-1} exp(-a_k^j))$$

La ième composante du vecteur $\underline{A}$ est donc :

$$A_i = Log_e \left( \sum_{j=0}^{q-1} exp(-z_j)/(1 + \sum_{k=1}^{q-1} exp(-a_k^j)) \right)$$

$$-Log_e \left( \sum_{j=0}^{q-1} exp(-a_i^j - z_j)/(1 + \sum_{k=1}^{q-1} exp(-a_k^j)) \right).$$

Cette expression n'est pas simple. On peut, comme dans le cas binaire, la mettre sous la forme du logarithme d'un rapport de sommes d'exponentielles, mais le nombre des termes en numérateur et en dénominateur croît comme $q^q$, q étant la taille de l'alphabet.

Dans le cas très général où les symboles d'entrée sont introduits k par k (et non un à un), il faut ci-dessus remplacer q par $q^k$ ; les composantes $a_i^j$ deviennent la somme des grandeurs de même forme associées séparément à chacun des k symboles introduits. Le calcul est donc formellement identique mais beaucoup plus complexe en pratique.

## Revendications

1. Procédé de décodage d'une suite de symboles binaires reçus d'un canal perturbé résultant du codage convolutif d'une suite de symboles binaires d'information à transmettre, lesdits symboles binaires d'information étant introduits un à un dans un codeur, défini par le treillis de ses états, ce treillis comprenant un ensemble de noeuds (S) et de branches, les noeuds étant rangés par niveaux de $2^m$ noeuds, où m est le nombre de symboles retardés dans le codeur, chaque noeud d'un niveau donné étant relié à deux noeuds du niveau précédent, appelés antécédents, par deux branches correspondant à deux symboles binaires d'information ; procédé dans lequel on détermine, en fonction de la suite des symboles binaires reçus, le chemin le plus vraisemblable dans le treillis, ceci définissant la suite la plus probable des symboles d'information binaires émis, ce chemin étant déterminé par récurrence sur les niveaux de noeuds successifs en conservant, dans une mémoire ($16_1$, ... $16_{L-1}$, 18) pour chaque noeud, le chemin le plus probable, appelé survivant, parmi les deux chemins y aboutissant et passant par les antécédents dudit noeud, le survivant en chaque noeud étant défini par une suite de valeurs relatives Xi indiquant une suite de symboles binaires et la vraisemblance de chacun de ces symboles, et par une mesure de la vraisemblance cumulée $v_c$ de cette suite, ledit procédé étant caractérisé en ce que chaque valeur relative X de la suite de valeurs relatives dans la mémoire d'un noeud est établie, à l'exception de la dernière valeur relative de cette suite, en fonction des valeurs relatives x', x'' correspondantes et en mémoire auxdits antécédents, et de la valeur relative z correspondant à la transition entre lesdits antécédents et ledit noeud suivant l'expression :

$$X = Log_e(e^{x''} + e^{x' + x''} + e^{x' + z} + e^{x' + x'' + z}) - Log_e(1 + e^{x'} + e^z + e^{x'' + z})$$

ou suivant l'expression approximative :

$$x = max(x'', x' + x'', x' + z, x' + x'' + z) - max(0, x', z, x'' + z),$$

ladite valeur relative z correspondant à la différence entre les vraisemblances cumulées $v'_c$ et $v''_c$, stockées dans les mémoires desdits antécédents, après augmentation de chaque vraisemblance

EP 0 210 932 B1

cumulée par la vraisemblance $v'_b$ respectivement $v''_b$ du symbole associé à la branche reliant l'antécédent correspondant audit noeud, la dernière valeur relative de la suite de valeurs relatives dudit noeud étant égale à ladite valeur relative z.

2. Décodeur pour le décodage d'une suite de symboles binaires reçus d'un canal perturbé résultant du codage convolutif d'une suite de symboles binaires d'information à transmettre, lesdits symboles binaires d'information étant introduits un à un dans un codeur, défini par le treillis de ses états, ce treillis comprenant un ensemble de noeuds (S) et de branches, les noeuds étant rangés par niveaux de $2^m$ noeuds, où m est le nombre de symboles retardés dans le codeur, chaque noeud d'un niveau donné étant relié à deux noeuds du niveau précédent, appelés antécédents, par deux branches correspondant à deux symboles binaires d'information, ledit codeur comprenant un module pour chaque état et un moyen pour relier les modules suivant les relations d'antécédence des noeuds du treillis correspondant au codeur, ledit décodeur étant caractérisé en ce que chaque module comprend :

- un ensemble de mémoires analogiques ($16_1$, ..., $16_{L-1}$) pour mémoriser une suite de valeurs relatives ($X_3$, ..., $X_L$, z) correspondant au noeud, sauf la valeur relative ($X_2$) la plus ancienne,
- une mémoire analogique (18) pour mémoriser la vraisemblance cumulée ($v_c$) du chemin représenté par la suite des valeurs relatives,
- un moyen de calcul (28-40) de ladite vraisemblance cumulée $v_c^1$ et $v_c^2$ en fonction des vraisemblances cumulées $v_c'$ et $v_c''$ des antécédents, et des vraisemblances $v_b'$ et $v_b''$ des branches reliant les antécédents audit noeud, et de calcul de la valeur relative z, selon les expressions :

$$v_c^1 = v_c' + v_b'$$
$$v_c^2 = v_c'' + v_b''$$
$$z = v_c^1 - v_c^2$$

- un ensemble de moyens de traitement ($42_2$, ..., $42_L$) ayant chacun trois entrées pour recevoir la valeur relative z, une valeur relative x' de la suite des valeurs relatives d'un antécédent du noeud et la valeur relative correspondante x" de la suite des valeurs relatives de l'autre antécédent du noeud, chaque moyen de traitement délivrant sur une sortie une valeur révisée ($X_2$, ..., $X_L$) suivant l'expression :

$$X = Log_e(e^{x''} + e^{x' + x''} + e^{x' + z} + e^{x' + x'' + z}) - log_e^{(1 + ex' + ez + ex'' + z)}$$

ou suivant l'expression approximative :

$$X = max(x'', x' + x'', x' + z, x' + x'' + z) - max(0, x', z, x'' + z),$$

chaque valeur révisée étant appliquée, sauf la valeur révisée ($X_2$) la plus ancienne, sur une entrée d'une mémoire analogique ($16_2$, ..., $16^{L-1}$) et la valeur relative la plus récente étant z.

3. Procédé de décodage d'une suite de symboles q-aires reçus d'un canal perturbé, résultant du codage convolutif d'une suite de symboles d'information q-aires à transmettre, lesdits symboles binaires d'information étant introduits k par k dans un codeur, défini par le treillis de ses états, ce treillis comprenant un ensemble de noeuds (S) et de branches, les noeuds étant rangés par niveaux de $q^{km}$ noeuds, où m est le nombre de paquets de k symboles retardés dans le codeur, chaque noeud d'un niveau donné étant relié à $q^k$ noeuds du niveau précédent, appelés antécédents, par $q^k$ branches correspondant à $q^k$ symboles q-aires d'information ; procédé dans lequel on détermine, en fonction de la suite des symboles q-aires reçus, le chemin le plus vraisemblable dans le treillis, ceci définissant la suite la plus probable des symboles d'information q-aires émis, ce chemin étant déterminé par récurrence sur les niveaux de noeuds successifs en conservant, dans une mémoire pour chaque noeud, le chemin le plus problable, appelé survivant, parmi les $q^k$ chemins y aboutissant et passant par les antécédents dudit noeud, le survivant en chaque noeud étant défini par une suite de vecteurs Ai, chaque vecteur ayant $q = 1$ composantes, la ième composante $1 \leq i \leq q-1$ étant une fonction du rapport des probabilités "symbole 0 émis" et "symbole i émis", le survivant en chaque noeud étant défini en outre par une mesure de la vraisemblance cumulée de cette suite, ledit procédé étant caractérisé en ce que chaque composante de chaque vecteur Ai de la suite de vecteurs dans la mémoire d'un noeud est établie, à l'exception du dernier vecteur de cette suite, en fonction des composantes des vecteurs

8

correspondants et en mémoire desdits antécédents et du vecteur z correspondant à la transition entre lesdits antécédents et ledit noeud selon l'expression suivante :

$$A_i = \log_e \left( \sum_{j=0}^{q-1} \exp(-z_j)/(1+ \sum_{k=1}^{q-1} \exp(-a_k^j)) \right)$$

$$- \log_e \left( \sum_{j=0}^{q-1} \exp(-a_i^j - z_j)/(1+ \sum_{k=1}^{q-1} \exp(-a_k^j)) \right).$$

où $a_i^j$ est la composante j du vecteur des valeurs relatives de l'antécédent j et où zj est la composante j du vecteur déterminé à partir des différences des vraisemblances associées aux divers chemins convergeant audit noeud, le dernier vecteur de la suite de vecteurs dudit noeud étant égal au vecteur correspondant à la transition entre lesdits antécédents et ledit noeud.

4. Décodeur pour le décodage d'une suite de symboles q-aires reçus d'un canal perturbé, résultant du codage convolutif d'une suite de symboles d'information q-aires à transmette, lesdits symboles binaires d'information étant introduits k par k dans un codeur, défini par le treillis de ses états, ce treillis comprenant un ensemble de noeuds (S) et de branches, les noeuds étant rangés par niveaux de $q^{km}$ noeuds, où m est le nombre de paquets de k symboles retardés dans le codeur, chaque noeud d'un niveau donné étant relié à $q^k$ noeuds du niveau précédent, appelés antécédents, par $q^k$ branches correspondant à $q^k$ symboles q-aires d'information, ledit décodeur comprenant un module pour chaque état et un moyen pour relier les modules suivant les relations d'antécédence du treillis correspondant au codeur, ledit décodeur étant caractérisé en ce que chaque module comprend :
   - un ensemble de mémoires analogiques pour mémoriser une suite des vecteurs $\underline{A}$ correspondant au noeud, sauf le vecteur le plus ancien,
   - une mémoire analogique pour mémoriser la vraisemblance cumulée du chemin représenté par la suite des vecteurs,
   - un moyen de calcul de ladite vraisemblance cumulée en fonction des vraisemblances cumulées des chemins des antécédents du noeud considéré et des vraisemblances des branches reliant lesdits antécédents audit noeud, et de calcul du vecteur correspondant à la transition entre lesdits antécédents et ledit noeud,
   - un ensemble de moyens de traitement ayant chacun $q^{km+1}$ entrées pour recevoir le vecteur correspondant à la transition entre lesdits antécédents et ledit noeud, et les vecteurs de niveaux de noeud identiques de chaque suite de vecteurs associée aux antécédents, chaque moyen de traitement délivrant sur une sortie une valeur révisée $\underline{A}$ appliquée, sauf la valeur révisée la plus ancienne qui est égale à $\underline{z}$, sur une entrée d'une mémoire analogique et dont la ième composante a l'expression suivante :

$$A_i = \log_e \left( \sum_{j=0}^{q-1} \exp(-z_j)/(1+ \sum_{k=1}^{q-1} \exp(-a_k^j)) \right)$$

$$- \log_e \left( \sum_{j=0}^{q-1} \exp(-a_i^j - z_j)/(1+ \sum_{k=1}^{q-1} \exp(-a_k^j)) \right).$$

où $a_i^j$ est la composante j du vecteur des valeurs relatives de l'antécédent j et où zj est la composante j du vecteur déterminé à partir des différences des vraisemblance associées aux divers chemins convergeant audit noeud.

## Claims

1. Process for decoding a sequence of binary symbols received from a disturbed channel resulting from the convolutional coding of a sequence of binary information symbols to be transmitted, the latter being introduced one by one into a coder defined by the lattice of its states, said lattice comprising a system of nodes (S) and branches, the nodes being arranged by levels of $2^m$ nodes, in which m is the number of symbols in the coder, each nose of a given level being connected to two nodes of the preceding level, called antecedents, by two branches corresponding to two binary information symbols, wherein as a function of the sequence of binary symbols received, the path of greatest likelihood in the lattice is defined, this defining the most probable sequence of binary information is transmitted, said path being determined by recurrence on the levels of successive nodes whilst retaining, in a memory ($16_1$, ... $16_{L-1}$ 18), for each node, the most probable path, called survivor, from among the two paths leading to it and passing through the antecedents of said node, the survivor in each node being defined by a sequence of relative values Xi indicating a sequence of binary symbols and the likelihood of each of these symbols, and by a measurement of the cumulative likelihood $v_c$ of said sequence, the process being characterized in that each relative value X of the sequence of relative values in the memory of a node is established with the exception of the final relative value of said sequence, as a function of the relative values x', x" in the memory and corresponding to said antecedents and of the relative value z corresponding to the transition between said antecedents and said node according to the expression:

$$X - Log_e(e^{x"} + e^{x'+x"} + e^{x'+z} + e^{x'+x"+z}) - log_e(1 + e^{x'} + e^z + e^{x"+z})$$

or according to the approximate expression:

$$X = \max(x", x'+x", x'+z, x'+x"+z) - \max(0, x', z, x"+z),$$

said relative value z corresponding to the difference between the cumulative likelihoods $v'_c$ and $v"_c$ stored in the memories of said antecedents, following the augmentation of each cumulative likelihood by the likelihood $v'_b$ respectively $v"_b$ of the symbol associated with the branch connecting the corresponding antecedent to the said node, the final relative value of the sequence of relative values of said node being equal to the said relative value z.

2. Decoder for decoding a sequence of binary symbols received from a disturbed channel resulting from the convolutive coding of a sequence of binary information symbols to be transmitted, the latter being introduced one by one into a coder, defined by the lattice of its states, said lattice having a plurality of nodes (S) and branches, the nodes being arranged by levels of $2^m$ nodes, in which m is the number of symbols delayed in the coder, each node of a given level being connected to two nodes of the preceding level, called antecedents, by two branches corresponding to two binary information symbols, said coder having a module for each state and a means for connecting the modules according to the antecedence relations of the nodes of the lattice corresponding to the coder, said decoder being characterized in that each module comprises:
a plurality of analog memories ($16_1$, ..., $16_{L-1}$) for storing a sequence of relative values ($X_3$, ..., $X_L$, z) corresponding to the node, except the oldest relative value ($X_2$),
an analog memory (18) for storing the cumulative likelihood ($v_c$) of the path represented by the sequence of relative values,
a calculating means (28-40) for said cumulative likelihood $v_c^1$ and $V_c^2$ as a function of the cumulative likelihoods $V'_c$ and $v"_c$ of the antecedents and the likelihoods $v'_b$ and $v'_b$ of the branches connecting the antecedents to said node, and calculating the relative value z, in accordance with the expressions:

$$v_c^1 = v'_c + v'_b$$
$$v_c^2 = v"_c + v"_b$$
$$z = v_c^1 - v_c^2$$

a plurality of processing means ($42_2$, ..., $42_L$), having three inputs for receiving the relative value z, a relative value x' of the sequence of relative values of one antecedent of the node and the corresponding relative value x" of the sequence of relative values of the other antecedent of the node, each processing means supplying to an output a revised value ($X_2$, ..., $X_L$) in accordance with the expression:

$$X = \text{Log}_e(e^{x''} + e^{x'+x''} + e^{x'+z} + e^{x'+x''+z}) - \text{log}_e(1 + e^{x'} + e^{z} + e^{x''+z})$$

or in accordance with the approximate expression:

$$X = \max(x'', x'+x'', x'+z, x'+x''+z) - \max(0, x', z, x''+z),$$

each revised value being applied, except for the oldest revised value ($X_2$), to an input of an analog memory ($16_2$, ..., $16_{L-1}$) and the most recent relative value is z.

3. Process for decoding a sequence of q-area symbols received from a disturbed channel, resulting from the convolutive coding of a sequence of q-area information symbols to be transmitted, said binary information symbols being introduced k by k into a coder, defined by the lattice of its states, said lattice having a plurality of nodes (S) and branches, the nodes being arranged by levels of $q^{km}$ nodes, in which m is the number of groups of k symbols delayed in the coder, each node of a given level being connected to $q^k$ nodes of the preceding level, called antecedents, by $q^k$ branches corresponding to $q^k$ q-area information symbols, whereby in said process determination takes place, as a function of the sequence of received q-area symbols, of the most likely path in the lattice, which defines the most probable sequence of the q-area information symbols transmitted, said path being determined by recurrence on the successive node levels whilst retaining, in a memory for each node the most probable path, called the survivor, among the $q^k$ paths leading to the same and passing through the antecedents of said node, the survivor in each node being defined by a sequence of vectors Ai, each vector having q-1 components, the ith component $1 \le i \le q-1$ being a function of the ratio of probabilities "symbol 0 transmitted" and "symbol i transmitted", the survivor in each node being defined by a measurement of the cumulative likelihood of said sequence, said process being characterized in that each component of each vector Ai of the sequence of vectors in the memory of a node is established, with the exception of the final vector of said sequence, as a function of the components of the corresponding vectors and in the memory of said antecedents and of the vector z corresponding to the transition between the said antecedents and the said node according to

$$A_i = \log_e\left(\sum_{j=0}^{q-1} \exp(-z_j) / (1 + \sum_{k=1}^{q-1} \exp(-a_k^j))\right)$$
$$-\log_e\left(\sum_{j=0}^{q-1} \exp(-a_i^j - z_j) / (1 + \sum_{k=1}^{q-1} \exp(-a_k^j))\right)$$

in which $a_j^i$ is the component j of the vector of the relative values of the antecedent j and in which zj is the component j of the vector determined on the basis of the differences of the likelihoods associated with the various paths converging to the said node, the final vector of the sequence of vectors of said node being equal to the vector corresponding to the transition between the said antecedents and the said node.

4. Decoder for decoding a sequence of q-area symbols received from a disturbed channel, resulting from the convolutive coding of a sequence of q-area information symbols to be transmitted, the latter being introduced k by k into a coder, defined by the lattice of its states, said lattice having a plurality of nodes (S) and branches, the nodes being arranged in levels of $q^{km}$ nodes, in which m is the number of groups of k symbols delayed in the coder, each node of a given level being connected to $q^k$ nodes of the preceding level, called antecedents, by $q^k$ branches corresponding to $q^k$ q-area formation symbols, said decoder having a module for each state and a means for connecting the modules accordance with the antecedence relationships of the lattice corresponding to the coder, said coder being characterized in that each module comprises a plurality of analog memories for storing a sequence of vectors A corresponding to the node, except for the oldest vector, an analog memory for storing the cumulative likelihood of the path represented by the sequence of vectors, a means for calculating said cumulative likelihood as a function of the cumulative likelihoods of the paths of the antecedents of the considered node and the likelihoods of the branches connecting said antecedents to said node and for calculating the vector corresponding to the transition between said antecedents and said node, a plurality of processing means each having $q^{km+1}$ inputs for receiving the vector corresponding to the transition between said antecedents and the said node and the vectors of the identical node levels of each sequence of vectors associated with the antecedents, each processing means supplying on an output a revised value A, which is applied, except for the oldest revised value which is equal to z, to an input of an analog memory and whereof the ith component has the following expression:

$$
A_i = \log_e \left( \sum_{j=0}^{q-1} \exp(-z_j)/(1+ \sum_{k=1}^{q-1} \exp(-a_k^j)) \right)
$$

$$
-\log_e \left( \sum_{j=0}^{q-1} \exp(-a_i^j - z_j)/(1+ \sum_{k=1}^{q-1} \exp(-a_k^j )) \right)
$$

in which $a_j^i$ is the component j of the vector of the relative values of the antecedent j and which $z_j$ is the component j of the vector determined on the basis of the differences of the likelihoods associated with the various paths converging at said node.

## Patentansprüche

1. Verfahren zum Dekodieren einer Folge binärer Symbole, die auf einem gestörten Kanal empfangen wurden und aus einer Faltungskodierung einer Folge zu sendender, binärer Symbole resultiert, wobei die binären Informationssymbole eines nach dem anderen in einen Kodierer eingeführt werden, der durch das Netz seiner Zustände definiert wird, wobei dieses Netz eine Anordnung von Knoten (S) und von Zweigen umfaßt, wobei die Knoten in Ebenen von $2^m$ Knoten angeordnet sind, wobei m die Zahl von in dem Kodierer verzögerten Symbole ist, wobei jeder Knoten einer gegebenen Ebene mit zwei Knoten der vorangehenden Ebene, vorhergehende Knoten genannt, über zwei zwei binären Informationssymbolen entsprechende Zweige verbunden ist; ein Verfahren, bei dem man in Abhängigkeit von der Folge von empfangenen, binären Symbolen den wahrscheinlichsten Weg in dem Netz bestimmt, was die wahrscheinlichste Folge von ausgesandten, binären Informationssymbolen definiert, wobei dieser Weg durch Rekursion in den Ebenen von aufeinander folgenden Knoten bestimmt wird, indem man in einem Speicher ($16_1$, ... $16_{L-1}$, 18) für jeden Knoten den wahrscheinlichsten Weg, genannt den überlebenden Weg, von den beiden Wegen, die dort enden und durch den vorhergenden Knoten dieses Knotens gehen, speichert, wobei der überlebende Weg in jedem Knoten durch eine Folge von relativen Werten Xi, die eine Folge von binären Symbolen und die Wahrscheinlichkeit Jedes dieser Symbole angibt, und durch ein kumuliertes Wahrscheinlichkeitsmaß $v_c$ für diese Folge definiert wird, wobei das Verfahren dadurch gekennzeichnet ist, daß jeder relative Wert x der Folge relativer Werte in dem Speicher eines Knotens mit der Ausnahme des letzten relativen Werts dieser Folge in Abhängigkeit von den entsprechenden relativen Werten x', x'' im Speicher der vorhergehenden Knoten und von dem relativen Wert z, der dem Übergang zwischen den vorhergehenden Knoten und diesem Knoten entspricht, entsprechend folgendem Ausdruck festgelegt wird:

$$
X = \log_e (e^{x''} + e^{x'+x''} + e^{x'+z} + e^{x'+x''+z}) - \log_e (1 + e^{x'} + e^z + e^{x''+z})
$$

oder entsprechend folgendem, angenähertem Ausdruck festgelegt wird:

$$
X = \max (x', x'+x'', x'+z, x'+x''+z) - \max (0, x', z, x''+z),
$$

wobei der relative Wert z der Differenz zwischen den kumulierten Wahrscheinlichkeiten $v'_c$ und $v''_c$ die in den Speichern der vorhergehenden Knoten gespeichert sind, nach Erhöhung jeder kumulierten Wahrscheinlichkeit durch die Wahrscheinlichkeit $v'_b$ beziehungsweise $v''_b$ des Symbols, das mit dem Zweig verbunden ist, der den entsprechenden vorhergehenden Knoten mit diesem Knoten verbindet, entspricht, wobei der letzte relative Wert der Folge von relativen Werten des Knotens gleich dem relativen Wert z ist.

2. Dekodierer zum Dekodieren einer Folge binärer Symbole, die auf einem gestörten Kanal empfangen wurden und aus einer Faltungskodierung einer Folge zu sendender, binärer Symbole resultiert, wobei die binären Informationssymbole eines nach dem anderen in einen Kodierer eingeführt werden, der durch das Netz seiner Zustände definiert wird, wobei dieses Netz eine Anordnung von Knoten (S) und von Zweigen umfaßt, wobei die Knoten In Ebenen von $2^m$ Knoten angeordnet sind, wobei m die Zahl von in dem Kodierer verzögerten Symbole ist, wobei jeder Knoten einer gegebenen Ebene mit zwei Knoten der vorangehenden Ebene, vorhergehende Knoten genannt, über zwei zwei binären Informationssymbolen entsprechende Zweige verbunden ist; wobei der Kodierer ein Modul für jeden Zustand und eine Vorrichtung zum Verbinden der Module entsprechend den Folgerelationen der dem Kodierer entsprechenden Knoten des Netzes umfaßt, wobei der Dekodierer dadurch gekennzeichnet ist, daß jedes Modul umfaßt:

- eine Anordnung von analogen Speichern ($16_1$, ..., $16_{L-1}$) zum Speichern einer Folge von relativen, dem Knoten entsprechenden Werten ($X_3$, ..., $X_L$, z) mit Ausnahme des ältesten relativen Werts ($X_2$),
- einen analogen Speicher (18) zum Speichern der kumulierten Wahrscheinlichkeit ($v_c$) des durch die Folge der relativen Werte dargestellten Wegs,
- eine Berechnungsvorrichtung (28-40) der kumulierten Wahrscheinlichkeit $v^1_c$ und $v^2_c$ in Abhängigkeit von den kumulierten Wahrscheinlichkeiten $v'_c$ und $v''_c$ der vorhergehenden Knoten und der Wahrscheinlichkeiten $v'_b$ und $v''_b$ der die vorhergehenden Knoten mit diesem Knoten verbindenden Zweige und eine Berechungsvorrichtung für den relativen Wert z entspre chend der Ausdrücke:

$$v^1_c = v'_c + v'_b$$
$$v^2_c = v''_c + v''_b$$
$$z = v^1_c - v^2_c$$

- eine Anordnung von Verarbeitungsvorrichtungen ($42_2$, ..., $42_L$) mit jeweils drei Eingängen zum Empfangen des relativen Wertes z, eines relativen Wertes x' der Folge der relativen Werte eines dem Knoten vorhergehenden Knoten und des entsprechenden relativen Wertes x" der Folge der relativen Werte des anderen dem Knoten vorhergehenden Knoten, wobei jede Bearbeitungsvorrichtung an einem Ausgang einen überarbeiteten Wert ($X_2$, ..., $X_L$) entsprechend dem folgenden Ausdruck ausgibt:

$$X = \log_e (e^{x''} + e^{x'+x''} + e^{x'+z} + e^{x'+x''+z}) - \log_e (1 + e^{x'} + e^z + e^{x''+z})$$

oder entsprechend folgendem, angenähertem Ausdruck ausgibt:

$$X = \max (x'', x'+x'', x'+z, x'+x''+z) - \max (0, x', z, x''+z),$$

wobei jeder überarbeitete Wert außer dem ältesten überarbeiteten Wert ($X_2$) an einen Eingang eines analogen Speichers ($16_2$, ..., $16_{L-1}$) angelegt wird und wobei der jüngste relative Wert z ist.

3. Verfahren zum Dekodieren einer Folge q-ärer Symbole, die auf einem gestörten Kanal empfangen wurden und aus einer Faltungskodierung einer Folge zu sendender, q-ärer Symbole resultiert, wobei die binären Informationssymbole k-weise in einen Kodierer eingeführt werden, der durch das Netz seiner Zustände definiert wird, wobei dieses Netz eine Anordnung von Knoten (S) und von Zweigen umfaßt, wobei die Knoten in Ebenen von $q^{km}$ Knoten angeordnet sind, wobei m die Zahl von Paketen mit k von in dem Kodierer verzögerten Symbole ist, wobei jeder Knoten einer gegebenen Ebene mit $q^k$ Knoten der vorangehenden Ebene, vorhergehende Knoten genannt, über $q^k$ Zweige, die $q^k$ q-ären Informationssymbolen entsprechen, verbunden ist; ein Verfahren, bei dem man in Abhängigkeit von der Folge von empfangenen, q-ären Symbolen den wahrscheinlichsten Weg in dem Netz bestimmt, was die wahrscheinlichste Folge von ausgesandten, q-ären Informationssymbolen definiert, wobei dieser Weg durch Rekursion in den Ebenen von aufeinander folgenden Knoten bestimmt wird, indem man in einem Speicher für jeden Knoten den wahrscheinlichsten Weg, genannt den überlebenden Weg, von

den $q^k$ Wegen, die dort enden und durch die vorhergenden Knoten dieses Knotens gehen, speichert, wobei der überlebende Weg in jedem Knoten durch eine Folge von Vektoren Ai definiert ist, wobei jeder Vektor q-1 Komponenten besitzt, wobei die i-te Komponente mit $1 \leq i \leq q-1$ eine Funktion des Verhältnisses der Wahrscheinlichkeiten "Symbol 0 ausgesandt" und "Symbol i ausgesandt" ist, wobei der überlebende Weg in jedem Knoten außerdem durch ein kumuliertes Wahrscheinlichkeitsmuß $v_c$ für diese Folge definiert wird, wobei das Verfahren dadurch gekennzeichnet ist, daß jede Komponente jedes Vektors Ai der Folge von Vektoren in dem Speicher eines Knotens mit der Ausnahme des letzten Vektors dieser Folge in Abhängigkeit von den Komponenten der entsprechenden Vektoren im Speicher der vorhergehenden Knoten und von dem Vektor z, der dem Übergang zwischen den vorhergehenden Knoten und diesem Knoten entspricht, ent sprechend folgendem Ausdruck festgelegt wird:

$$A_i = \log_e \left( \sum_{j=0}^{q-1} \exp(-z_j) / (1+ \sum_{k=1}^{q-1} \exp(-a^j_k)) \right)$$

$$- \log_e \left( \sum_{j=0}^{q-1} \exp(-a^j_i - z_j) / (1+ \sum_{k=1}^{q-1} \exp(-a^j_k)) \right)$$

wobei $a^j_i$ die Komponente j des Vektors der Werte bezüglich des vorhergehenden Knotens j ist und wobei $z_j$ die Komponente j des Vektors ist, der ausgehend von den Differenzen der Wahrscheinlichkeiten, die mit den verschiedenen Wegen, die an diesem Knoten enden, verbunden sind, bestimmt wird, wobei der letzte Vektor der Folge von Vektoren des Knotens gleich dem Vektor ist, der dem Übergang zwischen den vorhergehenden Knoten und diesem Knoten entspricht,

4. Dekodierer zum Dekodieren einer Folge q-ärer Symbole, die auf einem gestörten Kanal empfangen wurden und aus einer Faltungskodierung einer Folge zu sendender, q-ärer Symbole resultiert, wobei die binären Informationssymbole k-weise in einen Kodierer eingeführt werden, der durch das Netz seiner Zustände definiert wird, wobei dieses Netz eine Anordnung von Knoten (S) und von Zweigen umfaßt, wobei die Knoten in Ebenen von $q^{km}$ Knoten angeordnet sind, wobei m die Zahl von Paketen von K in dem Kodierer verzögerten Symbole ist, wobei jeder Knoten einer gegebenen Ebene mit $q^k$ Knoten der vorangehenden Ebene, vorhergehende Knoten genannt, über $q^k$ Zweige verbunden ist, die $q^k$ q-ären Informationssymbolen entsprechen; wobei der Kodierer ein Modul für jeden Zustand und eine Vorrichtung zum Verbinden der Module entsprechend den Folgerelationen der dem Kodierer entsprechenden Knoten des Netzes umfaßt, wobei der Dekodierer dadurch gekennzeichnet ist, daß jedes Modul umfaßt:
   - eine Anordnung von analogen Speichern zum Speichern einer Folge von dem Knoten entsprechenden Vektoren A mit Ausnahme des ältesten Vektors,
   - einen analogen Speicher zum Speichern der kumulierten Wahrscheinlichkeit des durch die Folge der Vektoren dargestellten Wegs,
   - eine Berechnungsvorrichtung der kumulierten Wahrscheinlichkeit in Abhängigkeit der kumulierten Wahrscheinlichkeiten der Wege der dem betrachteten Knoten vorhergehenden Knoten und der Wahrscheinlichkeiten der Zweige, die die vorhergehenden Knoten mit diesem Knoten verbinden, und eine Berechnungsvorrichtung für den Vektor, der dem Übergang zwischen den vorhergenden Knoten und diesem Knoten entspricht,
   - eine Anordnung von Verarbeitungsvorrichtungen mit jeweils $q^{km+1}$ Eingängen zum Empfangen des Vektors, der dem Übergang zwischen den vorhergehenden Knoten und diesem Knoten entspricht, und der Vektoren von identischen Knotenebenen jeder Vektorfolge, die mit den vorhergehenden Knoten verbunden ist, wobei jede Bearbeitungsvorrichtung an einem Ausgang einen überarbeiteten Wert A ausgibt, der mit Ausnahme des ältesten überarbeiteten Werts, der gleich z ist, an einen Eingang eines analogen Speichers angelegt wird und dessen i-te Komponente folgendem Ausdruck entspricht:

$$A_i = \log_e \left( \sum_{j=0}^{q-1} \exp(-z_j) / (1 + \sum_{k=1}^{q-1} \exp(-a^j{}_k)) \right)$$

$$- \log_e \left( \sum_{j=0}^{q-1} \exp(-a^j{}_i - z_j) / (1 + \sum_{k=1}^{q-1} \exp(-a^j{}_k)) \right)$$

wobei $a^j{}_i$ die Komponente j des Vektors der Werte bezüglich des vorhergehenden Knotens j ist und wobei $z_j$ die Komponente j des Vektors ist, der ausgehend von den Differenzen der Wahrscheinlichkeiten, die mit den verschiedenen Wegen, die an diesem Knoten enden, verbunden sind, bestimmt wird.

# FIG.1

# FIG.2

# FIG.3

$\{(x'_1, x'_2, \ldots, x'_L)$

$v'_C$

S'

N'

$\{(X_2(x'_2, x''_2, z), X (x'_3, x''_3, z)$

$, \ldots, X_L(x'_L, x''_L, z), z)$

$v_C$

S

N

$\{(x''_1, x''_2, \ldots, x''_L)$

$v''_C$

S''

N"

# FIG.4

y

$f = -z$

$f = y + z$

0

x

$f = y - z$

$f = z$

$f = x$

# FIG.5

EP 0 210 932 B1